(19) Europäisches Patentamt / European Patent Office / Office européen des brevets

(11) **EP 3 217 407 B1**

(12) **FASCICULE DE BREVET EUROPEEN**

(45) Date de publication et mention de la délivrance du brevet:
**22.08.2018 Bulletin 2018/34**

(51) Int Cl.:
*G11C 11/412* *(2006.01)*    *G11C 13/02* *(2006.01)*
*G11C 15/04* *(2006.01)*

(21) Numéro de dépôt: **17159614.1**

(22) Date de dépôt: **07.03.2017**

(54) **CELLULE MEMOIRE SRAM COMPRENANT UN N-TFET ET UN P-TFET**

SRAM-SPEICHERZELLE MIT N-TFET UND P-TFET

SRAM MEMORY CELL COMPRISING AN N-TFET AND A P-TFET

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.03.2016 FR 1652054**

(43) Date de publication de la demande:
**13.09.2017 Bulletin 2017/37**

(73) Titulaire: **Commissariat à l'énergie atomique et aux énergies alternatives
75015 Paris (FR)**

(72) Inventeurs:
• **GUPTA, Navneet
38000 GRENOBLE (FR)**
• **MAKOSIEJ, Adam
38000 GRENOBLE (FR)**
• **ANGHEL, Costin
92170 VANVES (FR)**
• **AMARA, Amara
92330 SCEAUX (FR)**

(74) Mandataire: **Brevalex
95, rue d'Amsterdam
75378 Paris Cedex 8 (FR)**

(56) Documents cités:
**US-A1- 2002 054 502    US-A1- 2007 045 741
US-A1- 2011 299 326    US-A1- 2012 106 236**

• **MING-LONG FAN ET AL: "Investigation of single-trap-induced random telegraph noise for tunnel FET based devices, 8T SRAM cell, and sense amplifiers", RELIABILITY PHYSICS SYMPOSIUM (IRPS), 2013 IEEE INTERNATIONAL, IEEE, 14 avril 2013 (2013-04-14), XP032678634, ISSN: 1541-7026, DOI: 10.1109/IRPS.2013.6532068 ISBN: 978-1-4799-0112-8 [extrait le 2013-06-13]**

**Description**

**DOMAINE TECHNIQUE ET ART ANTERIEUR**

L'invention concerne une nouvelle cellule de mémoire SRAM comprenant des transistors à effet de champ par effet tunnel (TFET) qui est capable de répondre aux exigences des applications à très basse puissance (ULP), comme l'Internet des objets (IoT), et d'être utilisée de manière avantageuse dans une architecture SRAM TFET/CMOS hybride.

L'augmentation constante de la demande sur le marché d'une plus grande durée de vie de batterie, de coûts réduits et de meilleures performances, particulièrement pour des dispositifs dans le domaine IoT, catalyse le développement de solutions consommant moins d'énergie. La surface et la puissance constituent donc les deux principales considérations de conception pour les systèmes sur puce (SoC) destinés à des applications IoT. Puisque, dans les SoC modernes, la SRAM peut dominer la consommation de puissance globale, particulièrement sa fuite, l'optimisation de SRAM pour réduire la consommation de puissance et la surface est donc importante pour maintenir une longue durée de vie de batterie sans sacrifier la capacité de SRAM sur puce.

Une approche d'optimisation de puissance de SRAM consiste à explorer des solutions en dehors de la technologie CMOS pour la conception de SRAM. Le TFET a été proposé en tant que solution possible pour réduire la dissipation de puissance. Le TFET fonctionne par effet tunnel bande à bande et, par conséquent, la pente sous le seuil (S) n'est pas limitée à 60 mV/dec comme dans le cas de CMOS. Des TFET fabriqués avec S de l'ordre de 30 mV/dec ont déjà été mesurés.

Les progrès réalisés avec les dispositifs TFET encouragent la poursuite de la recherche sur les circuits TFET. Une partie des rapports sur les cellules SRAM TFET utilisant des cellules 6T, 7T et 8T ont révélé des difficultés pour obtenir une stabilité suffisante dans les opérations de lecture et d'écriture. Le document US 2012/106236 montrent un exemple de cellule 6T. Puisque la stabilité dans les deux modes de fonctionnement est faible de manière inhérente en raison des performances électriques des TFET, il est difficile de trouver le meilleur équilibre entre la lecture et l'écriture. En outre, en raison du comportement unidirectionnel des TFET, il est nécessaire de cibler un fonctionnement à faible $V_{DD}$, ce qui accroît les difficultés pour obtenir des marges de stabilité suffisantes en mode actif.

Dans le document US 2011/0299326 A1, il est proposé une cellule SRAM 4T-TFET utilisant une propriété de résistance différentielle négative (NDR) des TFET en polarisation inverse. Néanmoins, l'architecture proposée dans ce document pâtit de problèmes de stabilité et de performances. Pour maintenir les données au cours d'une opération de lecture, le courant de lecture doit être inférieur au courant de bosse (dans la plage pA) fourni par la NDR. Une telle contrainte engendre une lecture extrêmement lente s'accompagnant du risque de corruption de données au cours de l'exécution de l'opération. En outre, la grille de transmission TFET pour l'accès aux données limite la tension de fonctionnement maximale.

**DESCRIPTION DE L'INVENTION**

Le but de la présente invention est de proposer une nouvelle architecture de cellule de mémoire SRAM ayant une consommation de puissance inférieure et supportant une grande plage de valeurs de tensions d'alimentation sans nuire à la stabilité des données.

L'invention propose ainsi une cellule mémoire SRAM comprenant au moins :

- un n-TFET et un p-TFET ;
- un noeud de stockage formé par la liaison d'une première électrode du n-TFET à une première électrode du p-TFET, les premières électrodes étant, dans une première configuration, les drains du n-TFET et du p-TFET, ou, dans une deuxième configuration, les sources du n-TFET et du p-TFET ;
- un circuit de commande apte à appliquer des tensions d'alimentation sur des deuxièmes électrodes du n-TFET et du p-TFET, les deuxièmes électrodes étant, dans la première configuration, les sources du n-TFET et du p-TFET, ou, dans la deuxième configuration, les drains du n-TFET et du p-TFET, et des tensions de polarisation sur les grilles du n-TFET et du p-TFET ;

dans lequel le circuit de commande est configuré pour fournir :

- au cours d'une rétention d'un bit stocké dans le noeud de stockage, des tensions d'alimentation et de polarisation qui polarisent en inverse le n-TFET et le p-TFET dans un état dans lequel un courant est obtenu par effet tunnel bande à bande ;
- au cours d'une écriture d'un bit dans le noeud de stockage, des tensions d'alimentation et de polarisation qui polarisent en direct le n-TFET et le p-TFET et telles que l'un du n-TFET et du p-TFET se trouve dans un état bloqué (OFF) et que l'autre du n-TFET et du p-TFET se trouve dans un état passant (ON).

La cellule mémoire SRAM utilise la propriété de résistance différentielle négative (NDR) des TFET polarisés en inverse au cours d'une rétention d'informations.

Au cours d'une opération d'écriture, puisque l'un des TFET est bloqué, que l'autre des TFET est passant et que les deux TFET sont polarisés en direct, la fuite est réduite et l'énergie nécessaire à la cellule mémoire est considérablement réduite par rapport à la cellule mémoire SRAM de l'art antérieur.

La nouvelle cellule mémoire SRAM supporte une réduction agressive de tension sans nuire à la stabilité des données de la cellule et elle permet l'application de techniques d'augmentation de performances sans impacter la fuite de cellule.

Cette nouvelle cellule mémoire SRAM maintient une stabilité raisonnable dans tous les modes de fonctionnement sans utiliser de technique d'assistance.

Cette cellule mémoire SRAM est compatible avec d'autres composants de mémoire CMOS (circuit d'attaque, organe de commande, etc.) pour une fabrication dans un processus CMOS FDSOI unique.

Au cours d'une écriture d'un bit dans le noeud de stockage, la valeur de la tension d'alimentation appliquée sur la deuxième électrode du n-TFET peut correspondre à la valeur de la tension d'alimentation appliquée sur la deuxième électrode du p-TFET au cours d'une rétention d'un bit stocké dans le noeud de stockage, et la valeur de la tension d'alimentation appliquée sur la deuxième électrode du p-TFET peut correspondre à la valeur de la tension d'alimentation appliquée sur la deuxième électrode du n-TFET au cours d'une rétention d'un bit stocké dans le noeud de stockage. Dans une telle configuration, les tensions d'alimentation appliquées sur les TFET au cours d'une écriture de bit dans le noeud de stockage sont inversées par rapport aux tensions d'alimentation appliquées sur les TFET au cours d'un mode de rétention. Il n'est donc pas nécessaire de fournir des valeurs de tension d'alimentation différentes dans le mode de rétention et dans le mode d'écriture.

Le circuit de commande peut être apte à fournir des tensions de polarisation différentes sur chacune des grilles du n-TFET et du p-TFET. Cette configuration permet d'obtenir la configuration la plus rapide pour une lecture et une écriture dans la cellule.

Dans la deuxième configuration, le circuit de commande peut être apte à fournir une tension de polarisation unique sur les grilles des n-TFET et p-TFET. Cette configuration permet de réduire le nombre de valeurs différentes pour les tensions d'alimentation et la tension de polarisation.

La cellule mémoire SRAM peut comprendre en outre :

- un port de lecture ayant une première électrode reliée au noeud de stockage ;
- une ligne de bits de lecture reliée à une deuxième électrode du port de lecture ;
- une première ligne de mots de lecture reliée à une troisième électrode du port de lecture ;

et dans laquelle le circuit de commande peut être configuré pour appliquer une tension de précharge sur la ligne de bits de lecture et une tension de commande de lecture sur la première ligne de mots de lecture.

Dans ce cas, le port de lecture peut comprendre un premier TFET de lecture, la première électrode peut correspondre à la grille du premier TFET de lecture, la deuxième électrode peut correspondre à l'un de la source et du drain du premier TFET de lecture et la troisième électrode peut correspondre à l'autre de la source et du drain du premier TFET de lecture. Un tel port de lecture est utilisé de manière avantageuse pour éviter, au cours d'une opération de lecture, une lecture d'autres cellules mémoires SRAM agencées sur la même ligne.

Le port de lecture peut en outre comprendre un deuxième TFET de lecture ayant une conductivité opposée à celle du premier TFET de lecture (c'est-à-dire un premier n-TFET de lecture et un deuxième p-TFET de lecture, ou un premier p-TFET de lecture et un deuxième n-TFET de lecture), dans lequel la grille du deuxième TFET de lecture est reliée au noeud de stockage, l'un de la source et du drain du deuxième TFET de lecture est relié à la ligne de bits de lecture et l'autre de la source et du drain du deuxième TFET de lecture est relié à une deuxième ligne de mots de lecture. Dans cette configuration, la cellule peut être utilisée dans une mémoire adressable par contenu (CAM).

L'invention concerne également un réseau de mémoires SRAM comprenant plusieurs cellules mémoires SRAM comme décrit ci-dessus, dans lequel les cellules mémoires SRAM sont agencées selon un réseau de plusieurs lignes et de plusieurs colonnes, et dans lequel :

- chaque ligne de bits de lecture est commune à toutes les cellules mémoires SRAM appartenant à une même colonne du réseau ;
- chaque ligne de mots de lecture est commune à toutes les cellules mémoires SRAM appartenant à une même ligne du réseau ;
- lorsque le circuit de commande est apte à fournir différentes tensions de polarisation sur chacune des grilles du n-TFET et du p-TFET, les grilles du n-TFET de toutes les cellules mémoires SRAM appartenant à une même colonne du réseau sont reliées l'une à l'autre et les grilles du p-TFET de toutes les cellules mémoires SRAM appartenant à une même colonne du réseau sont reliées l'une à l'autre ;

- lorsque le circuit de commande est apte à fournir une tension de polarisation unique sur les grilles du n-TFET et du p-TFET, les grilles du n-TFET et du p-TFET de toutes les cellules mémoires SRAM appartenant à une même colonne du réseau sont reliées l'une à l'autre.

L'invention concerne également un dispositif mémoire SRAM comprenant une pluralité de réseaux de mémoires SRAM comme décrit ci-dessus, dans lequel le circuit de commande est commun à la pluralité de réseaux de mémoires SRAM et comprend une pluralité de transistors CMOS.

**BREVE DESCRIPTION DES DESSINS**

D'autres caractéristiques et avantages de l'invention ressortiront plus clairement à la lecture de la description ci-après, faite en référence aux dessins annexés sur lesquels :

- la figure 1 représente la caractéristique $I_D(V_{DS})$ d'un n-TFET polarisé en inverse, pour différentes valeurs de $V_{GS}$ ;
- les figures 2a-2c représentent symboliquement les différents comportements d'un TFET polarisé en inverse ;
- la figure 3 représente des capacités de grille à source ($C_{GS}$) et de grille à drain ($C_{GD}$) de TFET en fonction de $V_{DS}$, obtenues pour différentes valeurs de $V_{GS}$ ;
- la figure 4 représente une cellule mémoire SRAM selon un premier mode de réalisation de l'invention ;
- la figure 5 représente la caractéristique $I_D(V_{Qint})$ avec une polarisation inverse $V_{DS}$ pour le n-TFET et le p-TFET de la cellule selon l'invention ;
- la figure 6 représente des formes d'onde de signaux de la cellule mémoire SRAM selon le premier mode de réalisation de l'invention et au cours d'opérations d'écriture ;
- la figure 7 représente des formes d'onde de signaux de la cellule mémoire SRAM selon l'invention et au cours d'une opération de lecture ;
- la figure 8 représente une cellule mémoire SRAM selon une variante du premier mode de réalisation de l'invention ;
- la figure 9 représente un réseau de cellules mémoires SRAM selon un mode de réalisation particulier de l'invention ;
- la figure 10 représente un dispositif mémoire SRAM selon un mode de réalisation particulier de l'invention ;
- la figure 11 représente les performances de lecture et d'écriture d'une cellule mémoire SRAM selon le premier mode de réalisation de l'invention ;
- la figure 12 représente une cellule mémoire SRAM selon un deuxième mode de réalisation de l'invention ;
- la figure 13 représente la caractéristique $I_D(V_{DS})$ d'un n-TFET polarisé en inverse pour différentes valeurs de $V_{GS}$ ;
- la figure 14 représente la caractéristique $I_D(V_{GS})$ d'un n-TFET polarisé en direct ;
- la figure 15 représente des formes d'onde de signaux de la cellule mémoire SRAM selon le deuxième mode de réalisation de l'invention et au cours d'opérations d'écriture ;
- la figure 16 représente les performances de lecture et d'écriture d'une cellule mémoire SRAM selon le deuxième mode de réalisation de l'invention ;
- la figure 17 représente une cellule mémoire SRAM selon un mode de réalisation particulier de l'invention ;
- la figure 18 représente une cellule mémoire SRAM selon une variante du premier mode de réalisation de l'invention.

Des parties identiques, similaires ou équivalentes des différentes figures décrites ci-après portent les mêmes numéros de référence sur toutes les figures par souci de clarté.
Les différentes parties représentées sur les figures ne sont pas forcément à l'échelle, afin que les figures soient plus compréhensibles.
Les différentes possibilités (variantes et modes de réalisation) ne doivent pas être comprises comme s'excluant mutuellement et elles peuvent ainsi être combinées entre elles.

**DESCRIPTION DETAILLEE DE MODES DE REALISATION PARTICULIERS**

Des TFET sont des jonctions de grilles p-i-n polarisées en inverse qui fonctionnent par effet tunnel, le potentiel électrostatique de la région intrinsèque étant commandé par une borne de grille. Les TFET utilisés dans les cellules mémoires SRAM décrites ci-après sont calibrés et conçus sur des données similaires à celles divulguées dans le document C. ANGHEL et al. : « 30-nm Tunnel FET with improved performance and reduced ambipolar current », IEEE Transactions on Electron Devices, 2011.
Par exemple :

- les TFET sont construits en utilisant des espaceurs à faible permittivité ($SiO_2$) et un diélectrique de grille à forte permittivité ($HfO_2$) ;
- la grille et les espaceurs ont chacun une longueur de 30 nm ;

- l'épaisseur physique du diélectrique de grille est de 3 nm ;
- l'épaisseur de film de silicium (tSi) utilisée pour former les régions de source, de drain et de canal est de 4 nm.

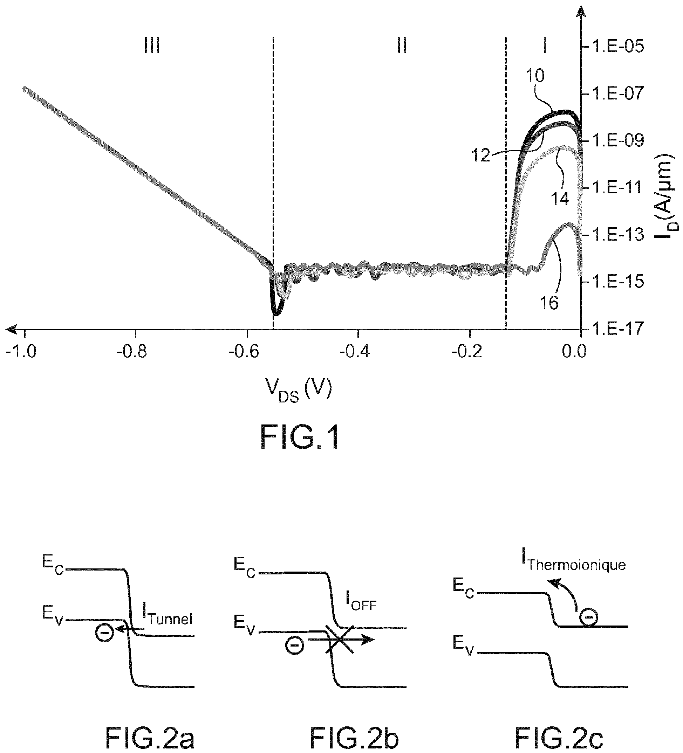

La figure 1 représente la caractéristique $I_D(V_{DS})$ d'un n-TFET polarisé en inverse, pour différentes valeurs de $V_{GS}$ : $V_{GS}$ = 1 V pour la courbe 10, $V_{GS}$ = 0,75 V pour la courbe 12, $V_{GS}$ = 0,5 V pour la courbe 14 et $V_{GS}$ = 0,25 V pour la courbe 16. Pour cette caractéristique, trois régions correspondant à trois comportements différents du TFET peuvent être distinguées comme suit :

- région I, appelée la « bosse », dans laquelle un courant de conduction $I_{Tunnel}$ est obtenu dans le TFET par un effet tunnel bande à bande (le mécanisme d'injection de charge correspondant à l'effet tunnel bande à bande est représenté symboliquement sur la figure 2a) ;
- région II, appelée la « région de courant plat », dans laquelle le courant de conduction obtenu dans la région I n'est plus obtenu parce que les bandes ne se chevauchent pas (comme cela est représenté symboliquement sur la figure 2b) ;
- région III, qui est appelée « état passant p-i-n », dans laquelle le mécanisme d'injection de charge est dominé par l'émission thermo-ionique au-dessus de la barrière, en créant un courant appelé $I_{Thermoionique}$ comme cela est représenté symboliquement sur la figure 2c. Dans cette région III, le TFET présente un comportement similaire à un court-circuit.

Pour la région III, la caractéristique de sortie polarisée en inverse est appelée « unidirectionnelle » parce que la grille perd le contrôle du TFET pour des tensions de drain négatives importantes.

Dans la cellule mémoire SRAM décrite ici, les TFET ne sont pas polarisés en inverse avec une tension $V_{DS}$ négative importante pour n-TFET (et $V_{DS}$ positive importante pour p-TFET) afin d'éviter des courants de fuite importants obtenus dans la région III, c'est-à-dire lorsque les TFET ont un comportement d' « état passant p-i-n ».

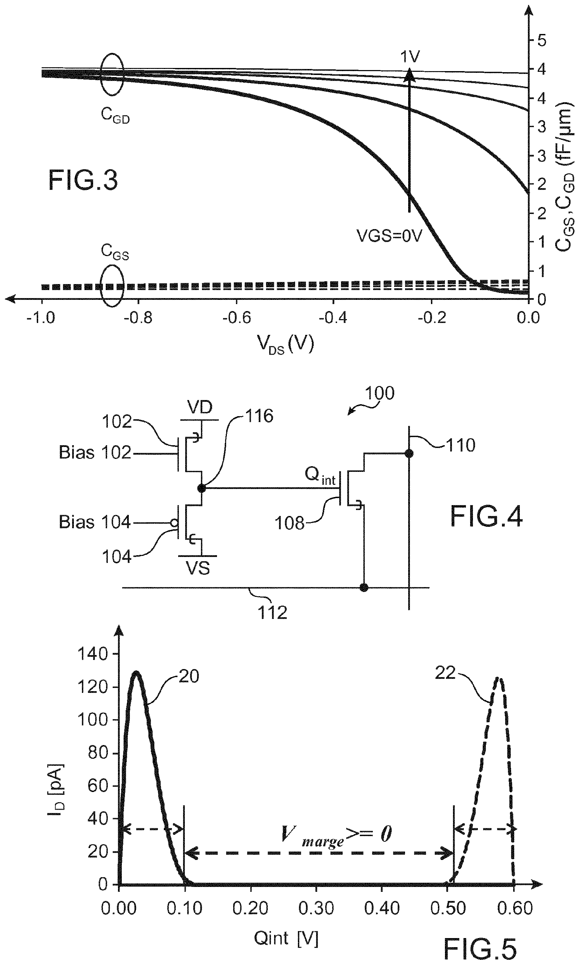

Les capacités de grille à source ($C_{GS}$) et de grille à drain ($C_{GD}$) de TFET sont représentées sur la figure 3. La $C_{GS}$ pour des TFET est toujours basse et présente une faible dépendance à la tension de grille. La capacité de grille totale est dominée par $C_{GD}$.

Pour les simulations de circuit suivantes, les p-TFET et n-TFET sont modélisés en utilisant des tables de référence. Des caractéristiques de courant continu et de capacité ont été mises en oeuvre sous forme de tables $I_D(V_{GS}, V_{DS})$, $C_{GS}(V_{GS}, V_{DS})$, $C_{GD}(V_{GS}, V_{DS})$.

Une cellule mémoire SRAM 100 selon un premier mode de réalisation est représentée sur la figure 4 et décrite ci-après.

La cellule 100 comprend un n-TFET 102 et un p-TFET 104. Les drains du n-TFET 102 et du p-TFET 104 sont reliés l'un à l'autre et forment un noeud de stockage 106 de la cellule 100. Le potentiel électrique dans le noeud de stockage 106 est appelé « Qint ».

Les TFET 102, 104 sont polarisés par une première tension d'alimentation $V_D$ appliquée sur la source du n-TFET 102 et une deuxième tension d'alimentation $V_S$ appliquée sur la source du p-TFET 104.

Deux tensions de polarisation différentes sont appliquées sur les grilles des TFET 102, 104. La tension de polarisation Bias102 est appliquée sur la grille du n-TFET 102 et la tension de polarisation BIas104 est appliquée sur la grille du p-TFET 104.

La cellule 100, qui est destinée à être utilisée dans un réseau de cellules mémoires, comprend également un TFET de lecture 108, ici de type n, dont le drain est relié à une ligne de bits de lecture (RBL) 110 et dont la source est reliée à une ligne de mots de lecture (RWL) 112.

Dans un mode de rétention de la cellule 100, les TFET 102, 104 sont polarisés en inverse avec $0 < V_D - V_S$. De plus, $V_D$ et $V_S$ sont tels que $V_D - V_S < 0,6$ V (parce que, dans les TFET utilisés dans l'exemple décrit ici, la limite entre les régions II et III en polarisation inverse est située à $V_{DS}$ égale à environ -0,6 V pour un n-TFET et 0,6 V pour un p-TFET). Les tensions de polarisation Bias102 et Bias104 sont définies de sorte que les n-TFET 102 et p-TFET 104 obtiennent une attaque de grille suffisant pour obtenir une bosse, c'est-à-dire que $V_{GS}$ soit suffisante pour avoir un courant créé par effet tunnel bande à bande lorsque ces TFET fonctionnent dans la région I de la caractéristique de polarisation inverse.

Dans l'exemple ci-dessous, $V_S$ = 0 V (masse) et $V_D$ = 0,6 V.

La caractéristique $I_D(V_{Qint})$ avec une polarisation inverse $V_{DS}$ pour le n-TFET 102 (courbe 22) et le p-TFET 104 (courbe 20) de la cellule 100 est représentée sur la figure 5, avec $V_D - V_S$ = 0,6 V (par exemple obtenue avec $V_S$ = 0 V et $V_D$ = 0,6 V). Cette caractéristique montre que le n-TFET 102 et le p-TFET 104 polarisés en inverse avec de telles tensions d'alimentation ont un comportement similaire à un comportement de verrou, à condition que l'alimentation de cellule totale ($V_D - V_S$) soit inférieure au point critique auquel le courant de TFET devient indépendant de la tension de grille (correspondant à la région III représentée sur la figure 1 dans laquelle les mécanismes d'injection de charge dans le TFET sont dominés par l'émission thermoionique au-dessus de la barrière). Dans l'exemple décrit ici, ce point est égal à environ 0,6 V. Ainsi, si Vs = 0 V, $V_D$ est choisie pour être inférieure ou égale à 0,6 V.

Puisque le p-TFET 104 conduit lorsque $V_{Qint}$ est proche de Vs et que le n-TFET 102 conduit lorsque $V_{Qint}$ est proche de $V_D$, une valeur « 0 » est stockée dans la cellule 100 sur le p-TFET 104, avec le n-TFET 102 à l'état OFF dans ce cas, et une valeur « 1 » est stockée dans la cellule 100 sur le n-TFET 102, avec le p-TFET 104 à l'état OFF dans ce cas. Pour une alimentation de cellule ($V_D$-$V_S$) de 0,6 V, le noeud de stockage 106 est déchargé à travers le p-TFET 104 pour 0 < Qint < 100 mv (plage correspondant à la largeur de la bosse, région I, de la caractéristique $I_D(V_{DS})$ du p-TFET 104) jusqu'à Qint = Vs, c'est-à-dire ici Qint = 0 V. De même, Qint est chargée à la valeur de $V_D$ par le n-TFET 102 pour 0,5 V < Qint < 0,6 V (plage correspondant à la largeur de la bosse, région I, de la caractéristique $I_D(V_{DS})$ du n-TFET 104).

La distance entre les deux bosses des caractéristiques $I_D(V_{DS})$ des TFET 102, 104 est appelée $V_{Marge}$ et correspond à la plage de tension dans laquelle la cellule 100 est métastable. Ici, les caractéristiques des TFET 102, 104 et les valeurs de $V_D$ et Vs sont telles que $V_{Marge} \geq 0$.

La valeur crête du courant obtenue au sommet des bosses des caractéristiques $I_D(V_{DS})$ des TFET 102, 104 varie avec la tension de grille appliquée (Bias102 et Bias104) mais la largeur de la bosse reste assez indépendante de la tension de grille, comme cela est représenté sur la figure 1.

Les contraintes de stabilité pour la cellule 100 sont significativement différentes de celles pour la cellule 6T-SRAM conventionnelle parce que le noeud de stockage de données 106 n'est pas isolé dans toutes les conditions de fonctionnement à l'exception de l'écriture. Par conséquent, la stabilité au cours des opérations de lecture et d'écriture est similaire à la marge de bruit statique de la cellule. Cela se traduit par une faible dépendance de la marge de bruit statique de cellule à la tension d'alimentation de cellule. Dans l'exemple décrit ici, cette cellule 100 a une marge de bruit statique de 100 mV (largeur de la bosse de courant) pour $V_{Marge} \geq 0$, c'est-à-dire lorsque $V_D$ - $V_S$ est entre 0,2 V et 0,6 V.

Ainsi, dans le mode de rétention, les tensions $V_D$, $V_S$, Bias102 et Bias104 sont telles que $V_{GS\_102} > 0$, $V_{DS\_102} \leq 0$, $V_{GS\_104} < 0$ et $V_{DS\_104} \geq 0$.

Pour l'écriture dans cette cellule 100, les n-TFET 102 et p-TFET 104 sont polarisés en direct en changeant $V_D$ et Vs, par exemple en commutant leurs valeurs, de sorte que les TFET 102 et 104 se comportent comme des FET, et commandent à la polarisation de grille de mettre le p-TFET 104 ou le n-TFET 102 à l'état bloqué en fonction de la valeur à écrire dans la cellule 100.

Pour l'écriture dans la cellule 100, les tensions $V_D$ et Vs sont inversées pour rendre Vs > $V_D$, les deux TFET 102, 104 étant ainsi polarisés en direct. Pour l'écriture de « 0 » dans le noeud 106, Bias104 est augmentée pour réduire l'attaque de grille du p-TFET 104 et Bias102 reste identique à sa valeur dans le mode de rétention. Ainsi, le n-TFET 102 décharge le noeud 106 à la tension sur $V_D$. De même, pour écrire « 1 » dans le noeud 106, Bias102 est réduite pour réduire l'attaque de grille du n-TFET 102 et Bias104 reste identique à sa valeur dans le mode de rétention. Par conséquent, le p-TFET 104 charge le noeud 106 à la tension sur Vs.

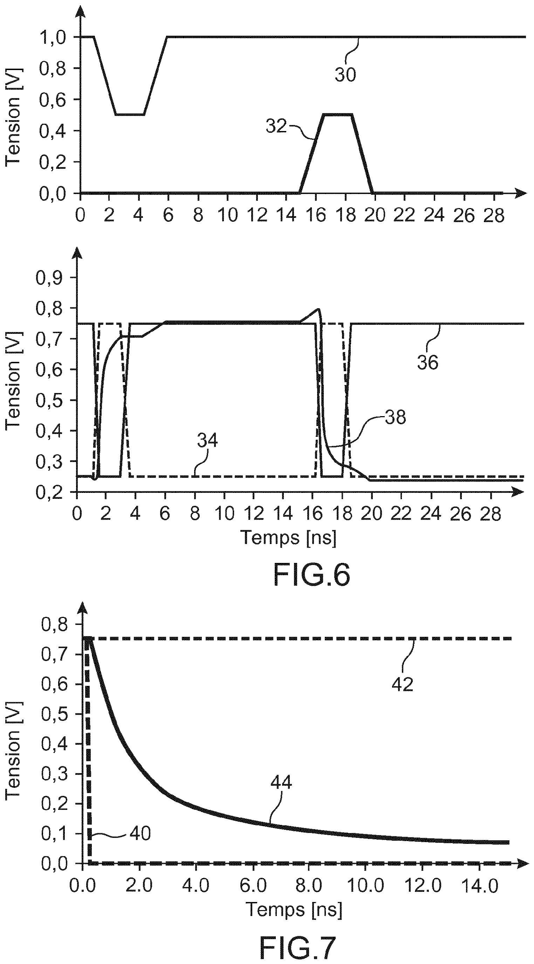

Des exemples de formes d'onde pour écrire « 1 » puis pour écrire « 0 » dans le noeud de stockage 106 de la cellule 100 sont représentés sur la figure 6. Le numéro de référence 30 désigne la tension de polarisation Bias102, le numéro de référence 32 désigne la tension de polarisation Bias104, le numéro de référence 34 désigne la tension d'alimentation Vs (représentée par une ligne pointillée), le numéro de référence 36 désigne la tension d'alimentation $V_D$, et le numéro de référence 38 désigne le potentiel $V_{Qint}$ obtenu dans le noeud de stockage 106.

Ainsi, au cours d'une écriture de « 0 » dans le noeud 106, les tensions $V_D$, Vs, Bias102 et Bias104 sont telles que $V_{GS\_102} > 0$, $I_{D\_102} = I_{ON\_102}$ (avec $I_{ON\_102}$ correspondant au courant ON du n-TFET 102), $V_{GS\_104} - V_{OFF\_104}$ (avec $V_{OFF\_104}$ correspondant au $V_{OFF}$ du p-TFET 104, c'est-à-dire la valeur $V_{GS}$ à laquelle le dispositif commence à conduire ; la valeur $V_{OFF}$ dépend directement de paramètres technologiques et peut être ajustée en modifiant des paramètres comme le dopage, le travail de sortie de grille, les dimensions physiques, le matériau, etc.) proche de 0 mais pas égal à 0 et avec $V_{GS\_104} > V_{OFF\_104}$, et $I_{D\_104}$ est positif et proche de 0 (mais pas égal à 0). Au cours d'une écriture de « 1 » dans le noeud 106, les tensions $V_D$, Vs, Bias102 et Bias104 sont telles que $V_{GS\_102} - V_{OFF\_102}$ (avec $V_{OFF\_102}$ correspondant au $V_{OFF}$ du n-TFET 102) soit proche de 0 mais pas égal à 0 et avec $V_{GS\_102} > V_{OFF\_102}$, $I_{D\_102} = 0$, $V_{GS\_104} < 0$ et $I_{D\_104} = I_{ON\_104}$ (avec $I_{ON\_104}$ correspondant au courant ON du p-TFET 104).

Une opération de lecture est effectuée en utilisant un schéma de lecture asymétrique avec RWL 112 et RBL 110. RWL 112 sélectionne la ligne du réseau de cellule à lire. RBL 110 est déchargé ou reste à une valeur préchargée. RBL peut se décharger complètement ou un amplificateur de détection asymétrique peut être utilisé. Un déchargement complet est préférable pour une opération à basse tension et pour maintenir le pas de colonne pour un circuit de lecture. L'amplificateur de détection peut être un inverseur avec une tension de seuil biaisée. Pour une lecture correcte, une décharge d'au moins 50 % de la tension d'alimentation est de préférence appliquée pour RBL 110.

Des exemples de formes d'onde pour une opération de lecture sont représentés sur la figure 7, pour lire la valeur stockée dans le noeud 106 de la cellule 100. Pour une telle lecture, la valeur de la tension appliquée sur RWL 102 est changée d'une valeur correspondant à celle d'un bit « 1 » stocké, égale à $V_D$ (par exemple 0,75 V sur la figure 7), à une valeur correspondant à celle d'un bit « 0 » stocké, par exemple 0 V (courbe 40). Si une valeur « 0 » est stockée dans le noeud de stockage 106, la valeur de la tension sur RBL 110 reste à une valeur correspondant à un « 1 » (courbe 42). Si une valeur « 1 » est stockée dans le noeud de stockage 106, la valeur de la tension sur RBL 110 devient « 0 » (courbe 44).

Si le TFET de lecture 108 correspond à un p-TFET, la courbe 42 s'applique pour une valeur « 1 » stockée dans le noeud de stockage 106 et la courbe 44 s'applique pour une valeur « 0 » stockée dans le noeud de stockage 106. Avec un tel p-TFET de lecture, RBL 110 est préchargé avec une valeur correspondant à « 0 », la valeur appliquée sur RWL 112 est « 0 » au cours d'une rétention et la valeur appliquée sur RWL 112 est « 1 » au cours d'une lecture.

Compte tenu du comportement décrit ci-dessus de la cellule 100, le fonctionnement de la cellule 100 dans les différents modes (rétention, écriture et lecture) nécessite l'utilisation de cinq valeurs de tension différentes pour $V_D$, Vs, Bias102 et Bias104. Ces valeurs peuvent être appelées GND, VDDL, VDD, VDDH et 2VDD (c'est-à-dire 2*VDD) et sont telles que :

$$GND < VDDL < VDD < VDDH < 2VDD.$$

Il est possible que la valeur 2VDD ne corresponde pas à 2*VDD mais corresponde à une valeur supérieure à VDDH.

L'utilisation de ces cinq valeurs pour les différentes tensions de la cellule 100 au cours des opérations de rétention, de lecture et d'écriture est représentée dans le tableau ci-après.

|  | $V_D$ | $V_S$ | RWL 112 | RBL 110 | Bias104 | Bias102 |
|---|---|---|---|---|---|---|
| Rétention | VDDH | VDDL | VDDH | VDDH | GND | 2VDD |
| Ecriture 1 | VDDL | VDDH | VDDH | VDDH | GND | VDD |
| Ecriture 0 | VDDL | VDDH | VDDH | VDDH | VDD | 2VDD |
| Lecture | VDDH | VDDL | GND | VDDH | GND | 2VDD |

Par exemple, ces valeurs peuvent être telles que :

| GND | VDDL | VDD | VDDH | 2VDD |
|---|---|---|---|---|
| 0 V | 0,25 V | 0,5 V | 0,75 V | 1V |

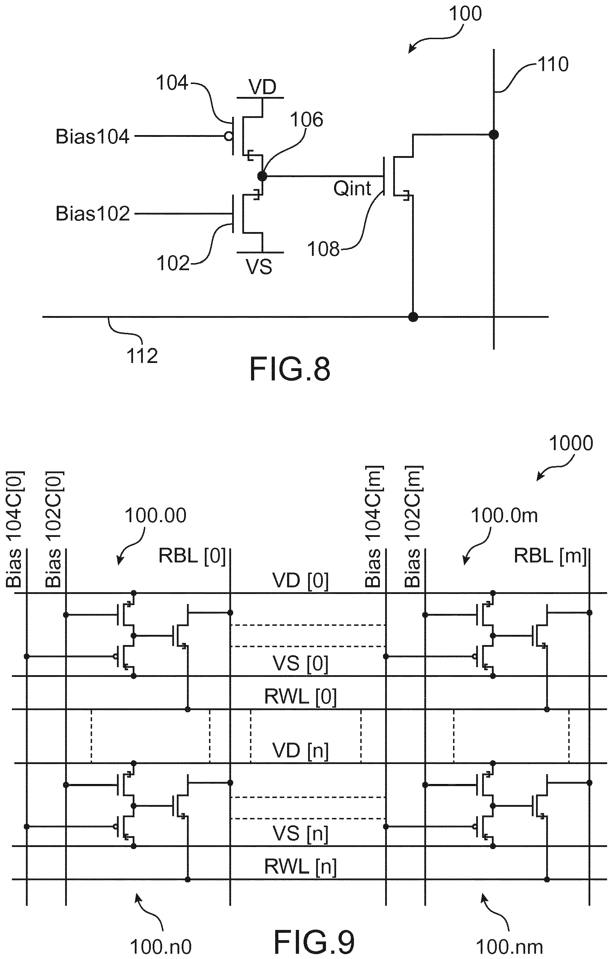

Une cellule mémoire SRAM 100 selon une variante du premier mode de réalisation est représentée sur la figure 8.

Selon cette variante, la tension d'alimentation $V_D$ est appliquée sur le drain du p-TFET 104 et la tension d'alimentation Vs est appliquée sur le drain du n-TFET 102. Les sources du n-TFET 102 et du p-TFET 104 sont reliées au noeud de stockage 106 de la cellule 100.

Le comportement de la cellule 100 selon cette variante est proche de celui de la cellule 100 précédemment décrite.

Dans le mode de rétention, les tensions $V_D$, $V_S$, Bias102 et Bias104 appliquées dans la cellule 100 selon cette variante sont telles que : $V_{GS\_102} \geq 0$, $V_{DS\_102} \leq 0$, $V_{GS\_104} \leq 0$ et $V_{DS\_104} \geq 0$.

Au cours d'une écriture de « 0 » dans le noeud de stockage 106, les valeurs des tensions $V_D$, Vs, Bias102 et Bias104 sont telles que $V_{GS\_102}$ - $V_{OFF\_102}$ soit proche de 0 mais pas égal à 0 et avec $V_{GS\_102} > V_{OFF\_102}$, $I_{D\_102}$ est positif et proche de 0, $V_{GS\_104} \leq 0$ et $I_{D\_104} = I_{ON\_104}$. Au cours d'une écriture de « 1 » dans le noeud de stockage 106, les valeurs des tensions $V_D$, Vs, Bias102 et Bias104 sont telles que $V_{GS\_102} \geq 0$, $I_{D\_102}$ est proche de $I_{ON\_102}$, $V_{GS\_104}$ - $V_{OFF\_104}$ est proche de 0 mais pas égal à 0 et avec $V_{GS\_104} < V_{OFF\_104}$ et $I_{D\_104}$ est positif et proche de 0.

La cellule 100 précédemment décrite en relation avec la figure 4 fournit une grande vitesse d'écriture et une basse capacité sur des noeuds d'alimentation (sur lesquels $V_D$ et Vs sont appliquées) en raison de la $C_{GS}$ basse dans les TFET 102, 104 et de la $V_{GS}$ constante au cours de l'écriture pour les TFET 102, 104. Dans la cellule représentée sur la figure 8, la tension $V_{GS}$ des TFET 102, 104 change continuellement avec la valeur de Qint au cours d'une opération d'écriture en raison des sources des TFET 102, 104 reliées au noeud de stockage 106. Ainsi, la vitesse d'écriture de la cellule 100 de la figure 8 est inférieure à celle de la cellule 100 de la figure 4. Néanmoins, la cellule 100 selon la variante représentée sur la figure 8 est meilleure en termes de stabilité en raison du plus grand courant de bosse dû à la plus grande valeur de $V_{GS}$ pour les TFET 102, 104 dans le mode de rétention.

La cellule 100 de la figure 4 ou de la figure 8 est destinée à être couplée à plusieurs autres cellules 100 similaires pour former un réseau de cellules mémoires SRAM 1000, comme cela est représenté sur la figure 9.

La figure 9 représente l'organisation du réseau 1000 comprenant l'acheminement des signaux. Le réseau de cellules mémoires comprend ici n lignes et m colonnes de n x m cellules 100.00 à 100.nm. Des mots de données sont stockés horizontalement. $V_D$ et Vs sont acheminées horizontalement pour s'aligner avec le mot de données et sont communes à toutes les cellules agencées dans une même ligne du réseau. Bias102 et Bias104 sont acheminées verticalement et elles sont communes à toutes les cellules agencées dans une même colonne du réseau. Dans cette architecture, la sélection de la ligne à écrire est effectuée en choisissant les valeurs de $V_D$ et Vs de chaque ligne du réseau, et la valeur à écrire dans chaque cellule 100 est décidée par les valeurs de Bias102 et Bias104 de chaque colonne. La sélection de la ligne à lire est effectuée par les valeurs appliquées sur RWL 112 de chaque ligne du réseau 1000 et les données sont lues en utilisant RBL 110.

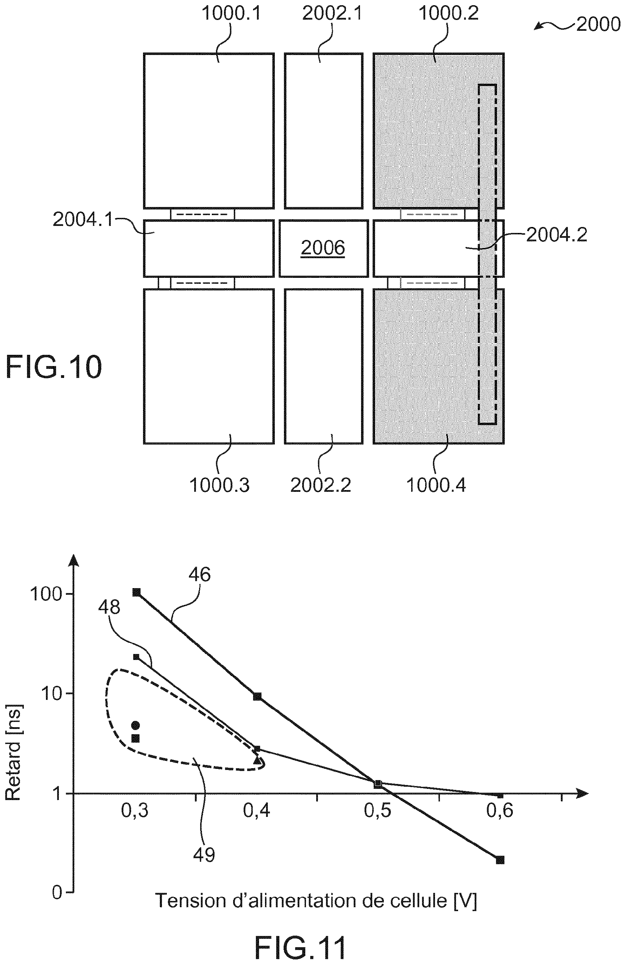

Un dispositif mémoire SRAM 2000 proposé est représenté sur la figure 10. Le dispositif mémoire 2000 comprend quatre réseaux SRAM TFET de 64x32 cellules (portant les numéros de référence 1000.1 à 1000.4, chacun comprenant 64 lignes de 32 cellules 100), deux circuits d'attaque de lignes de mots 2002.1 et 2002.2 utilisés pour commander les valeurs appliquées sur RWL 112, $V_D$ et Vs, deux logiques d'entrée/sortie 2004.1 et 2004.2 utilisées pour commander les valeurs appliquées sur RBL 110 et les valeurs de Bias102 et Bias104 et pour détecter les valeurs sur RBL 110 en utilisant un amplificateur de détection afin de fournir une sortie de données au cours d'une opération de lecture, et un organe de commande 2006 commandant le fonctionnement du dispositif mémoire 2000.

Pour optimiser le courant de fuite de réseau de cellules, les réseaux de cellules 1000 sont entièrement conçus de manière avantageuse avec des TFET. Les autres éléments du dispositif mémoire 2000 peuvent être conçus en utilisant des CMOS pour optimiser la surface afin d'obtenir la même vitesse de fonctionnement qu'avec les TFET en raison d'une plus grande force d'attaque. Un amplificateur de détection asymétrique peut être utilisé pour limiter la décharge de ligne de bits afin de réduire la consommation d'électricité et de permettre une plus grande taille de colonne.

Avec les cellules 100 précédemment décrites, un réseau de cellules d'une taille de 64x32 (2 Kb) peut être réalisé avec une taille de cellule égale à 0,1266 $\mu m^2$/bit avec des règles de conception de logique standard.

Dans chaque cellule 100, le TFET 108 (200 nm) sur le port de lecture peut avoir deux fois la taille des TFET 102, 104 (100 nm). Cela améliore la vitesse de lecture de l'ensemble.

Pour améliorer la disposition rectangulaire des cellules, deux cellules peuvent être combinées dans une configuration de six transistors. En raison de la largeur de cellule réduite, les capacités de câblage sur les diverses lignes horizontales dans le réseau de cellules sont réduites. Les valeurs extraites de capacités de câblage de la configuration sont de 50 % en comparaison de la même taille de mémoire conçue en utilisant une cellule 6T-SRAM compacte.

En raison de la faible capacité de cellules et de la faible capacité $C_{GS}$ des dispositifs TFET, la capacité totale des noeuds d'alimentation sur lesquels les tensions $V_D$ et Vs sont appliquées et de RWL 112 est inférieure à la moitié par rapport au standard 6T-CMOS. Par conséquent, les circuits d'attaque (pour RWL 112, $V_D$ et Vs) ont moins de fuite pour la même spécification de temps de transition et de taille de mot.

Pour la conception proposée, la consommation d'énergie est calculée selon les postulats suivants : pour un calcul d'énergie moyenne ($E_{AVG}$), au cours de la lecture, 50 % des données sont « 0 » et 50 % des données sont « 1 » ; 50 % des opérations sont une lecture et 50 % des opérations sont une écriture. Une comparaison globale de la consommation d'énergie dans divers modes et diverses surfaces de cellules est représentée dans le tableau ci-après (ces valeurs sont des résultats expérimentaux spécifiques à une technologie, des règles de conception et une conception, et elles peuvent changer pour différentes tailles, différentes technologies et différentes règles de conception).

| Cellule | VDD (V) | WL$_{pulse}$ Lecture (ns) | WL$_{pulse}$ Ecriture (ns) | E$_{READ}$ (fJ/acc.) | E$_{WRITE}$ (fJ/acc.) | E$_{AVG}$ (fJ/acc.) |
|---|---|---|---|---|---|---|
| 8T-TFET | 1 | 0,26 | 1,10 | 28,5 | 61,0 | 44,8 |
| 3T-TFET 100 | 0,6 | 0,21 | 0,93 | 1,81 | 4,99 | 3,4 |
| 6T-CMOS | 1,2 | 7 ns (temps accès pour toute la mémoire) | | Néant | Néant | 25 $\mu$W/MHz |

| Cellule | I$_{LEAK}$ actif (pA/bit) | I$_{LEAK}$ veille (pA/bit) | Surface/cellule ($\mu m^2$) |
|---|---|---|---|
| 8T-TFET | 25,5 | 5,00 | 0,336 |
| 3T-TFET 100 | 5,72 | 0,35 | 0,1266 |
| 6T-CMOS | Néant | 27,00 | 2,04 |

La cellule 8T-TFET correspond à celle décrite dans le document A. Makosiej et al. : « A 32 nm Tunnel FET SRAM for Ultra Low Leakage », ISCAS, 2012. La cellule 6T-CMOS correspond à celle décrite dans le document Toshikazu Fukuda, Koji Kohara et al. : « A 7ns-Access-Time 25μW/MHz 128kb SRAM for Low-Power Fast Wake-Up MCU in 65 nm CMOS with 27fA/b Rétention Current », ISSCC 2014.

$E_{READ}$ est l'énergie consommée au cours de la lecture sur des circuits d'attaque de ligne et des lignes de bits. La décharge de ligne de bits de lecture est limitée à 50 % de l'alimentation (200 mV) pour des SRAM 3T-TFET et 8T-TFET parce qu'elles utilisent une détection asymétrique. La décharge de ligne de bits de lecture est limitée à 100 mV pour une cellule 6T-SRAM avec une lecture différentielle. $E_{WRITE}$ est l'énergie consommée au cours d'une opération d'écriture. $I_{LEAK}$ en mode actif est la fuite totale dans le réseau de cellules et à la périphérie avec une mise en oeuvre de grille de puissance dynamique (uniquement 25 % des circuits d'attaque sont mis sous tension en fonction de l'adresse accédée). $I_{LEAK}$ en mode de veille est calculée avec la périphérie hors tension et le réseau de cellules sous tension pour la rétention des données.

La consommation de puissance de fuite des circuits d'attaque de lignes de mots pour la cellule 3T-TFET 100 a été comparée à celle des cellules 6T-SRAM et SRAM 8T-TFET pour la même spécification de temps de transition. La fuite de réseau de cellules 100 est 77x inférieure à celle de la cellule 6T-CMOS. La fuite de la cellule 100 est 14x inférieure à celle des cellules SRAM 8T-TFET. En veille, la fuite totale provient du réseau de cellules, et la fuite de mémoire TFET est donc largement inférieure à celle des mémoires CMOS. La fuite de mémoire globale en mode actif, y compris pour les cellules et les circuits d'attaque, dans la conception proposée est inférieure de 52 % à celle de la cellule 6T-CMOS et de 77 % à celle de la cellule SRAM 8T-TFET.

En raison de la faible capacité sur les noeuds d'alimentation (sur lesquels $V_D$ et Vs sont appliquées) et sur RWL 112, la consommation de puissance dynamique de la cellule 100 est inférieure de 70 % à celle de la cellule 6T-CMOS SRAM et jusqu'à 90 % à celle de la cellule SRAM 8T-TFET.

La largeur d'impulsion de ligne de mots minimale (WLP$_{crit}$) de lecture (portant le numéro de référence 46) et d'écriture (portant le numéro de référence 48) est représentée sur la figure 11. Sur toute la plage de fonctionnement, la fuite de cellule est inférieure à 0,35 fA/bit parce que les TFET 102, 104 sont en polarisation inverse. Comme cela est représenté sur la figure 11, la vitesse de lecture/écriture peut être augmentée en utilisant des techniques d'assistance pour un fonctionnement à basse tension (cf. les résultats entourés des lignes pointillées 49). Puisque le noeud de stockage de données de cellule 106 est isolé de RBL 110 et des tensions de polarisation des TFET 102, 104, une ligne de mots négative (NWL) peut être utilisée pour accroître la vitesse de lecture sans nuire à la stabilité de cellule. De même que pour l'écriture, la vitesse peut être accrue sans nuire à la stabilité de cellule en augmentant les tensions de polarisation (Bias102 et Bias104). Les performances de lecture sont améliorées de 29x, en utilisant une ligne de mots négative (RWL) avec -100 mV et -150 mV respectivement pour des alimentations de 0,4 V et 0,3 V. De même que pour l'écriture, une augmentation de 100 mV de la tension de polarisation engendre une amélioration de 4,8x pour une alimentation de cellule de 0,3 V.

Une impulsion minimale d'accès de lecture et d'écriture est évaluée à 1,27 ns à une tension d'alimentation inférieure à 1 V.

Les performances globales sont estimées en tenant compte des retards à la périphérie dans le décodeur de ligne, les circuits d'attaque et la détection. La conception proposée supporte une vitesse de lecture globale de 1,92 GHz à 3,82 MHz et une vitesse d'écriture de 429 MHz à 17,3 MHz pour une alimentation de cellule de 0,6 V à 0,3 V, avec Bias102 et Bias104 de 1,2 V à 0,6 V. Cela inclut cinq tensions globales (précédemment appelées GND, VDDL, VDD, VDDH, 2VDD). Cela peut être mis en oeuvre avec cinq tensions d'alimentation différentes ou trois tensions d'alimentation différentes avec deux diviseurs de tension.

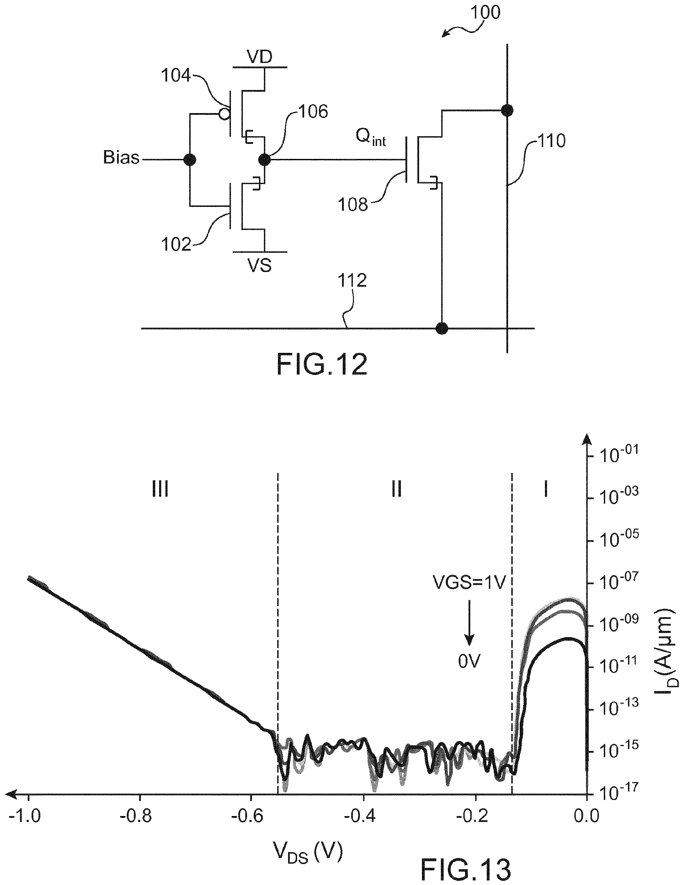

Une cellule mémoire SRAM 100 selon un deuxième mode de réalisation va être décrite ci-après en référence la figure 12.

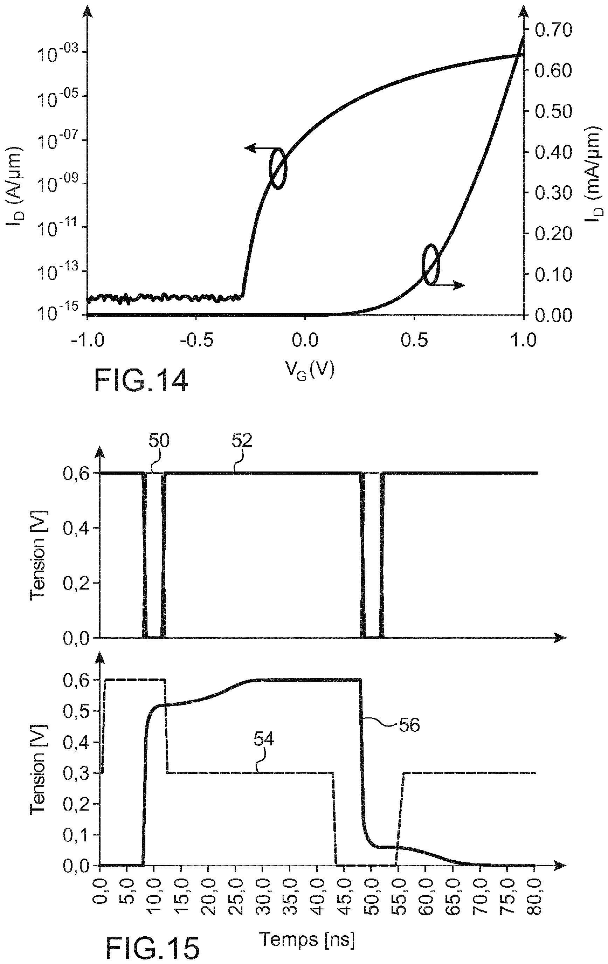

La cellule 100 selon ce deuxième mode de réalisation comprend les mêmes éléments que ceux précédemment décrits pour la cellule 100 de la figure 8. Néanmoins, les TFET 102, 104 sont ici conçus de sorte que, au cours d'une polarisation inverse, dans la région de bosse, le courant $I_D$ ne soit pas nul même si $V_{GS}$ est égal à 0. La caractéristique $I_D(V_{DS})$ d'un tel n-TFET polarisé en inverse, pour différentes valeurs de $V_{GS}$ (de 1 V à 0 V) est représentée sur la figure 13. La caractéristique $I_D(V_G)$ d'un tel n-TFET polarisé en direct est représentée sur la figure 14. De tels TFET peuvent être réalisés en fonction des informations données dans les documents C. ANGHEL et al. : « 30-nm Tunnel FET with improved performance and reduced ambipolar current », IEEE Transactions on Electron Devices, 2011.

De plus, au lieu d'avoir deux tensions de polarisation différentes appliquées sur les grilles des TFET 102, 104, une seule tension de polarisation appelée « Bias » est appliquée sur la grille du n-TFET 102 et sur la grille du p-TFET 104.

Comme pour les cellules 100 précédemment décrites en référence aux figures 4 et 8, dans un mode de rétention de la cellule 100 selon ce deuxième mode de réalisation, les TFET 102 et 104 sont polarisés en inverse avec $0 < V_D -$ Vs $\leq 0{,}6$ V. De plus, la tension de polarisation Bias est maintenue entre $V_D$ et Vs de sorte que les deux dispositifs obtiennent une attaque de grille suffisante pour une bosse, c'est-à-dire de sorte que $V_{GS}$ soit suffisante pour avoir un courant de conduction créé par effet tunnel bande à bande (néanmoins, cela est toujours le cas si les TFET 102, 104 sont conçus de sorte que le courant $I_D$ ne soit pas nul même si $V_{GS}$ est égale à 0).

La caractéristique ID($V_{Qint}$) représentée sur la figure 5 correspond à la caractéristique obtenue pour cette cellule 100 lorsque le signal Bias est maintenu à 0 V.

Dans le mode de rétention, pour une alimentation de cellule ($V_D$ - Vs) de 0,6 V, le noeud de stockage 106 est déchargé à travers le n-TFET 102 pour 0 V < Qint < 100 mV jusqu'à Qint = 0 V. De même, le noeud de stockage 106 est chargé par le p-TFET 104 pour 0,5 V < Qint < 0,6 V, comme pour la cellule 100 précédemment divulguée en référence à la figure 8. Cela engendre un comportement de verrou avec un « 0 » stocké sur le n-TFET 102 ou un « 1 » stocké sur le p-TFET 104.

A la différence de la cellule 6T-SRAM, la stabilité de la cellule 100 au cours des opérations de lecture est similaire à celle de la rétention parce que le noeud de stockage 106 est isolé au cours des opérations de lecture. Pour une écriture réussie, Qint doit être dans la plage de tension de bosse, puis le courant de bosse effectue l'écriture en chargeant le noeud de stockage 106 à la tension d'alimentation ou en déchargeant le noeud de stockage 106 à la masse. Par conséquent, la marge de bruit (ici égale à environ 100 mV) pour l'écriture est également définie par la largeur de bosse.

Pour l'écriture dans la cellule 100, les tensions d'alimentation $V_D$ et Vs sont inversées pour obtenir Vs > $V_D$. Les TFET 102, 104 sont ainsi polarisés en direct et se comportent comme des FET et la polarisation de grille est alors commandée pour affaiblir l'un des n-TFET 102 et p-TFET 104 et pour renforcer l'autre de ceux-ci en fonction de la valeur à écrire dans le noeud de stockage 106 de la cellule 100. Pour écrire un « 0 », Bias est augmentée pour augmenter l'attaque de grille du n-TFET 102 et pour réduire l'attaque de grille du p-TFET 104. Ainsi, n-TFET 102 décharge le noeud 106 à une tension ayant la valeur de Vs. De même, pour écrire un « 1 », Bias est réduite pour augmenter l'attaque de grille du p-TFET 104 et pour réduire l'attaque de grille du n-TFET 102. Ainsi, le p-TFET 104 charge le noeud 106 à la valeur de la tension d'alimentation $V_D$.

Des formes d'onde pour l'écriture de « 0 » et « 1 » sont représentées sur la figure 15. Sur cette figure, le numéro de référence 50 correspond à la tension d'alimentation Vs (ligne pointillée) et le numéro de référence 52 correspond à la tension d'alimentation $V_D$. Le numéro de référence 54 correspond à la tension de polarisation Bias et le numéro de référence 56 correspond au potentiel Qint.

Une opération de lecture est effectuée selon un schéma de lecture asymétrique en utilisant RWL 112 et RBL 110, comme cela a été précédemment divulgué. Les formes d'onde pour les opérations de lecture sont similaires à celles représentées sur la figure 7.

Compte tenu du comportement décrit ci-dessus de la cellule 100 selon le deuxième mode de réalisation, le fonctionnement de la cellule 100 dans les différents modes (rétention, écriture et lecture) ne nécessite que l'utilisation de trois tensions différentes $V_D$, Vs et Bias. Ces valeurs peuvent être appelées GND, VDD/2 et VDD et sont telles que :

$$GND < VDD/2 < VDD.$$

La valeur VDD/2 peut être remplacée par une autre valeur qui est entre GND et VDD.

L'utilisation de ces tensions pour les différents signaux de la cellule 100 du deuxième mode de réalisation au cours des opérations de rétention, de lecture et d'écriture est représentée dans le tableau ci-après.

|           | $V_D$ | $V_S$ | Bias  | RWL 112 | RBL 110          |
|-----------|-------|-------|-------|---------|------------------|
| Rétention | VDD   | GND   | VDD/2 | VDD     | VDD              |
| Ecriture 1| GND   | VDD   | VDD   | VDD     | VDD              |
| Ecriture 0| GND   | VDD   | GND   | VDD     | VDD              |
| Lecture   | VDD   | GND   | VDD/2 | GND     | Valeur de lecture |

Dans un exemple, ces tensions peuvent avoir les valeurs suivantes :

| GND | VDD/2 | VDD   |
|-----|-------|-------|
| 0 V | 0,3 V | 0,6 V |

La cellule 100 de la figure 12 est destinée à être utilisée avec d'autres cellules similaires pour former un réseau de cellules mémoires, comme le réseau de cellules mémoires 1000 représenté sur la figure 9. Dans ce réseau, Bias est acheminé verticalement et la valeur à écrire dans chaque cellule est décidée par la valeur de Bias.

Avec la cellule 100 de la figure 12, une mémoire ayant une architecture similaire à celle de la mémoire 2000 représentée sur la figure 10 peut être réalisée.

Avec la cellule 100 de la figure 12, un réseau de cellules d'une taille de 64x32 (2 Kb) peut être réalisé avec une taille de cellule égale à 0,10 $\mu m^2$/bit selon des règles de conception de logique standard.

Comme pour les cellules précédemment décrites, une comparaison de la consommation d'énergie dans divers modes et diverses surfaces de cellules est représentée dans le tableau ci-après (ces valeurs sont des résultats expérimentaux spécifiques à une technologie, des règles de conception et une conception, et elles peuvent changer pour différentes tailles, différentes technologies et différentes règles de conception).

| Cellule | VDD (V) | WLpulse Lecture (ns) | WLpulse Ecriture (ns) | $E_{READ}$ (fJ/acc.) | $E_{WRITE}$ (fJ/acc.) | $E_{AVG}$ (fJ/acc.) |
|---|---|---|---|---|---|---|
| 8T-TFET | 1 | 0,26 | 1,10 | 28,5 | 61,0 | 44,8 |
| 3T-TFET 100 | 0,45 | 15 | 15 | 1,22 | 2,06 | 1,64 |
| 3T-TFET 100 | 0,6 | 1,961 | 8,03 | 2,18 | 3,66 | 2,92 |
| 6T-CMOS | 1,2 | 7 ns (temps accès pour toute la mémoire) | | Néant | Néant | 25 $\mu$W/MHz |

| Cellule | $I_{LEAK}$ actif (pA/bit) | $I_{LEAK}$ veille (pA/bit) | Surface/cellule ($\mu m^2$) |
|---|---|---|---|
| 8T-TFET | 25,5 | 5,00 | 0,336 |
| 3T-TFET 100 | 5,72 | 0,1 | 0,108 |
| 3T-TFET 100 | 5,72 | 17 | 0,108 |
| 6T-CMOS | Néant | 27,00 | 2,04 |

En veille, la fuite totale provient du réseau de cellules. Par conséquent, la fuite de mémoire TFET est largement inférieure à celle des mémoires CMOS. La vitesse de lecture/écriture et la consommation d'énergie dynamique sont améliorées en raison des faibles capacités sur les noeuds d'alimentation et sur RWL 112.

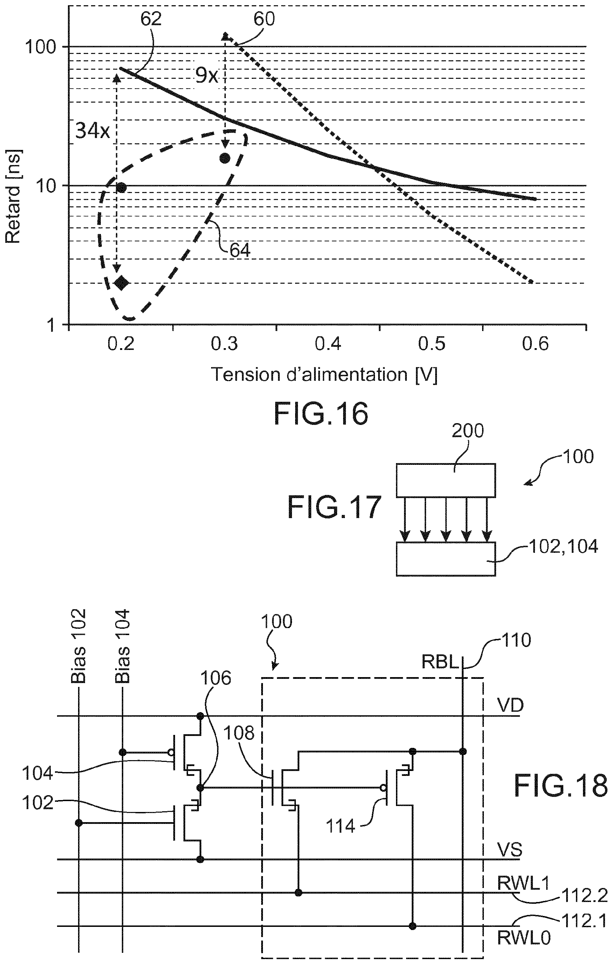

La largeur minimale (WLPcrit) d'impulsion de ligne de mots de lecture (portant le numéro de référence 60) et d'écriture (portant le numéro de référence 62) est représentée sur la figure 16. Pour une tension de fonctionnement inférieure à 0,5 V, la fuite de cellule est inférieure à 0,1 fA/bit parce que chacun des TFET 102, 104 est toujours polarisé en inverse. Pour une alimentation supérieure à 0,5 V, la vitesse est améliorée au détriment d'une plus grande fuite en raison de l'augmentation du courant inverse de TFET.

Comme cela est représenté sur la figure 16, la vitesse de lecture et d'écriture peut être augmentée en utilisant des techniques d'assistance pour un fonctionnement à basse tension (cf. les résultats entourés par les lignes pointillées 64). Puisque le noeud de stockage de données de cellule 106 est isolé de RBL 110 et des tensions de polarisation de TFET 102, 104, une ligne de mots de lecture négative (NRWL) peut être utilisée pour augmenter la vitesse de lecture sans nuire à la stabilité de cellule. De même que pour l'écriture, la vitesse peut être augmentée en accroissant les tensions de polarisation. Les performances de lecture sont améliorées de plus de 8x en utilisant NRWL respectivement avec -100 mV et -150 mV pour des alimentations de 0,3 V et 0,2 V respectivement. De même que pour l'écriture, une augmentation de 100 mV de la tension de polarisation est utilisée au-dessous d'une alimentation de cellule de 0,3 V pour améliorer la vitesse d'écriture de plus de 34x.

Les performances globales sont estimées en tenant compte des retards à la périphérie dans le décodeur de ligne, les circuits d'attaque et la détection. La conception proposée supporte une vitesse de lecture globale de 204 MHz à 3,16 MHz et une vitesse d'écriture de 50 MHz à 13 MHz pour une alimentation de cellule de 0,6 V à 0,3 V.

Ainsi, la cellule 100 selon ce deuxième mode de réalisation permet de fonctionner avec seulement trois tensions différentes, au lieu des cinq tensions nécessaires au fonctionnement de la cellule 100 selon le premier mode de réalisation, avec néanmoins l'inconvénient de plus faibles vitesses de lecture et d'écriture de la cellule par rapport au premier mode de réalisation.

Dans les premier et deuxième modes de réalisation précédemment divulgués, la cellule 100 comprend un TFET 108 formant le port de lecture de la cellule 100. Néanmoins, un autre type de port de lecture comprenant des transistors TFET et/ou CMOS peut être utilisé au lieu d'un seul TFET.

La figure 17 représente la cellule 100 comprenant un circuit de commande 200 fournissant les différents signaux (les tensions $V_D$, $V_S$, Bias, ou Bias102 et Bias104, tensions pour RBL 110 et RWL 112) aux éléments de la cellule 100, particulièrement les TFET 102, 104.

La figure 18 représente une cellule mémoire SRAM 100 selon une variante du premier mode de réalisation.

Selon cette variante, la cellule 100 comprend, en plus du premier TFET de lecture 108, un deuxième TFET de lecture 114. Lorsque le premier TFET de lecture 108 est un n-TFET, le deuxième TFET de lecture 114 est un p-TFET. Lorsque le premier TFET de lecture 108 est un p-TFET, le deuxième TFET de lecture 114 est un p-TFET.

Dans l'exemple représenté sur la figure 18, le premier TFET de lecture 108 est un n-TFET et le deuxième TFET de lecture 114 est un p-TFET. Le drain du deuxième p-TFET de lecture 114 est relié à une première RWL0 (portant le numéro de référence 112.1) et la source du n-TFET de lecture 108 est reliée à une deuxième RWL1 (portant le numéro de référence 112.2). Le drain du premier n-TFET de lecture 108 et la source du deuxième p-TFET 114 sont reliés à la RBL 110.

La structure d'une telle cellule 100 permet de réaliser une mémoire adressable par contenu (CAM). Les valeurs appliquées sur les RWL 112.1 et 112.2 dépendent de la valeur des données recherchées. Dans l'exemple représenté sur la figure 18, si les données recherchées correspondent à « 1 », la valeur appliquée sur RWL0 112.1 est basse (« 0 ») et la valeur appliquée sur RWL1 112.2 est haute (« 1 »). Si les données recherchées correspondent à « 0 », la valeur appliquée sur RWL0 112.1 est haute et la valeur appliquée sur RWL1112.2 est basse. En cas de désaccord entre la valeur recherchée et la valeur stockée dans le noeud de stockage 106, la valeur sur RBL 110 est déchargée.

Dans la description ci-dessus, les données concernant la fuite, la surface, la puissance et la vitesse sont des résultats expérimentaux qui peuvent varier en fonction de la taille, de la mise en oeuvre et des technologies. De plus, les différentes valeurs d'exemples données pour les différentes tensions peuvent varier en fonction de la taille, de la mise en oeuvre et des technologies utilisées.

## Revendications

1. Cellule mémoire SRAM (100) comprenant au moins :

   - un n-TFET (102) et un p-TFET (104) ;
   - un noeud de stockage (106) formé par la liaison d'une première électrode du n-TFET à une première électrode du p-TFET, les premières électrodes étant, dans une première configuration, les drains du n-TFET et du p-TFET, ou, dans une deuxième configuration, les sources du n-TFET et du p-TFET ;
   - un circuit de commande (200) apte à appliquer des tensions d'alimentation sur des deuxièmes électrodes du n-TFET et du p-TFET, les deuxièmes électrodes étant, dans la première configuration, les sources du n-TFET et du p-TFET, ou, dans la deuxième configuration, les drains du n-TFET et du p-TFET, et des tensions de polarisation sur les grilles du n-TFET et du p-TFET ;

   dans laquelle le circuit de commande est configuré pour fournir :

   - au cours d'une rétention d'un bit stocké dans le noeud de stockage, des tensions d'alimentation et de polarisation qui polarisent en inverse le n-TFET et le p-TFET dans un état dans lequel un courant de conduction est obtenu par effet tunnel de bande à bande dans le n-TFET et dans le p-TFET ;
   - au cours d'une écriture d'un bit dans le noeud de stockage, des tensions d'alimentation et de polarisation qui polarisent en direct le n-TFET et le p-TFET et telles que l'un du n-TFET et du p-TFET se trouve dans un état bloqué et que l'autre du n-TFET et du p-TFET se trouve dans un état passant.

2. Cellule mémoire SRAM (100) selon la revendication 1, dans laquelle, au cours d'une écriture d'un bit dans le noeud de stockage (106), la valeur de la tension d'alimentation appliquée sur la deuxième électrode du n-TFET (102) est égale à la valeur de la tension d'alimentation appliquée sur la deuxième électrode du p-TFET (104) au cours d'une rétention d'un bit stocké dans le noeud de stockage, et la valeur de la tension d'alimentation appliquée sur la deuxième électrode du p-TFET est égale à la valeur de la tension d'alimentation appliquée sur la deuxième électrode du n-TFET au cours d'une rétention d'un bit stocké dans le noeud de stockage.

3. Cellule mémoire SRAM (100) selon l'une des revendications précédentes, dans laquelle le circuit de commande (200) est apte à fournir des tensions de polarisation différentes sur chacune des grilles du n-TFET (102) et du p-TFET (104).

4. Cellule mémoire SRAM (100) selon la revendication 3, dans laquelle, au cours de la rétention d'un bit stocké dans le noeud de stockage (106), la valeur de la tension de polarisation appliquée sur la grille du n-TFET (102) est supérieure à la valeur des tensions d'alimentation appliquées sur les deuxièmes électrodes des n-TFET et p-TFET (104), et la valeur de la tension de polarisation appliquée sur la grille du p-TFET est inférieure à la valeur des tensions d'alimentation appliquées sur les deuxièmes électrodes des n-TFET et p-TFET.

5. Cellule mémoire SRAM (100) selon l'une des revendications 3 et 4, dans laquelle, au cours d'une écriture d'un bit dans le noeud de stockage (106) :

- dans la première configuration, la valeur de la tension de polarisation appliquée sur la grille du n-TFET (102) est entre les valeurs des tensions d'alimentation appliquées sur les deuxièmes électrodes des n-TFET et p-TFET (104) si le bit est « 1 » et la valeur de la tension de polarisation appliquée sur la grille du p-TFET est entre les valeurs des tensions d'alimentation appliquées sur les deuxièmes électrodes des n-TFET et p-TFET si le bit est « 0 » ;
- dans la deuxième configuration, la valeur de la tension de polarisation appliquée sur la grille du p-TFET est entre les valeurs des tensions d'alimentation appliquées sur les deuxièmes électrodes des n-TFET et p-TFET si le bit est « 1 » et la valeur de la tension de polarisation appliquée sur la grille du n-TFET est entre les valeurs des tensions d'alimentation appliquées sur les deuxièmes électrodes des n-TFET et p-TFET si le bit est « 0 ».

6. Cellule mémoire SRAM (100) selon l'une des revendications 1 et 2, dans laquelle, dans la deuxième configuration, le circuit de commande (200) est apte à fournir une tension de polarisation unique sur les grilles du n-TFET (102) et du p-TFET (104).

7. Cellule mémoire SRAM (100) selon la revendication 6, dans laquelle, au cours de la rétention d'un bit stocké dans le noeud de stockage (106), la valeur de la tension de polarisation appliquée sur les grilles du n-TFET (102) et du p-TFET (104) est entre les valeurs des tensions d'alimentation appliquées sur les deuxièmes électrodes des n-TFET et p-TFET.

8. Cellule mémoire SRAM (100) selon l'une des revendications 6 et 7, dans laquelle, au cours d'une écriture d'un bit dans le noeud de stockage (106), la valeur de la tension de polarisation appliquée sur les grilles du n-TFET (102) et du p-TFET (104) est égale à la plus grande valeur parmi les valeurs des tensions d'alimentation appliquées sur les deuxièmes électrodes des n-TFET et p-TFET si le bit est « 1 », et la valeur de la tension de polarisation appliquée sur les grilles des n-TFET et p-TFET est égale à la plus petite valeur parmi les valeurs des tensions d'alimentation appliquées sur les deuxièmes électrodes des n-TFET et p-TFET si le bit est « 0 ».

9. Cellule mémoire SRAM (100) selon l'une des revendications précédentes, comprenant en outre :

- un port de lecture (108, 114) ayant une première électrode reliée au noeud de stockage (106) ;
- une ligne de bits de lecture (110) reliée à une deuxième électrode du port de lecture ;
- une première ligne de mots de lecture (112) reliée à une troisième électrode du port de lecture ;

et dans laquelle le circuit de commande (200) est configuré pour appliquer une tension de précharge sur la ligne de bits de lecture et une tension de commande de lecture sur la première ligne de mots de lecture.

10. Cellule mémoire SRAM (100) selon la revendication 9, dans laquelle le port de lecture comprend un premier TFET de lecture (108), la première électrode correspondant à la grille du premier TFET de lecture, la deuxième électrode correspondant à l'un de la source et du drain du premier TFET de lecture et la troisième électrode correspondant à l'autre de la source et du drain du premier TFET de lecture.

11. Cellule mémoire SRAM (100) selon la revendication 10, dans laquelle le port de lecture comprend en outre un deuxième TFET de lecture (114) ayant une conductivité opposée à celle du premier TFET de lecture, dans laquelle la grille du deuxième TFET de lecture est reliée au noeud de stockage (106), l'un de la source et du drain du deuxième TFET de lecture est relié à la ligne de bits de lecture (110) et l'autre de la source et du drain du deuxième TFET de lecture est relié à une deuxième ligne de mots de lecture (112).

12. Réseau de cellules mémoires SRAM (1000) comprenant plusieurs cellules mémoires SRAM (100) selon l'une des revendications 9 à 11, dans lequel les cellules mémoires SRAM sont agencées selon un réseau de plusieurs lignes et de plusieurs colonnes, et dans lequel :

- chaque ligne de bits de lecture (110) est commune à toutes les cellules mémoires SRAM appartenant à une

13

même colonne du réseau ;

- chaque ligne de mots de lecture (112) est commune à toutes les cellules mémoires SRAM appartenant à une même ligne du réseau ;

- lorsque le circuit de commande (200) est apte à fournir différentes tensions de polarisation sur chacune des grilles du n-TFET (102) et du p-TFET (104), les grilles du n-TFET de toutes les cellules mémoires SRAM appartenant à une même colonne du réseau sont reliées les unes aux autres et les grilles du p-TFET de toutes les cellules mémoires SRAM appartenant à une même colonne du réseau sont reliées les unes aux autres ; ou

- lorsque le circuit de commande est apte à fournir une tension de polarisation unique sur les grilles du n-TFET et du p-TFET, les grilles du n-TFET et du p-TFET de toutes les cellules mémoires SRAM appartenant à une même colonne du réseau sont reliées les unes aux autres.

13. Dispositif mémoire SRAM (2000) comprenant une pluralité de réseaux de cellules mémoires SRAM (1000) selon la revendication 12, dans lequel le circuit de commande (2002.1, 2002.2, 2004.1, 2004.2, 2006) est commun à la pluralité de réseaux de cellules mémoires SRAM et comprend une pluralité de transistors CMOS.

**Patentansprüche**

1. SRAM-Speicherzelle (100), wenigstens umfassend:

- einen n-TFET (102) und einen p-TFET (104);

- einen Speicherknoten (106), welcher durch die Verbindung einer ersten Elektrode des n-TFET mit einer ersten Elektrode des p-TFET gebildet ist, wobei die ersten Elektroden in einer ersten Konfiguration die Drains des n-TFET und des p-TFET oder in einer zweiten Konfiguration die Sources des n-TFET und des p-TFET sind;

- eine Steuerschaltung (200), welche in der Lage ist, Versorgungsspannungen an zweiten Elektroden des n-TFET und des p-TFET anzulegen, wobei die zweiten Elektroden in der ersten Konfiguration die Sources des n-TFET und des p-TFET oder in der zweiten Konfiguration die Drains des n-TFET und des p-TFET sind, sowie Polarisationsspannungen an die Gates des n-TFET und des p-TFET;

wobei die Steuerschaltung dazu eingerichtet ist, zu liefern:

- während eines Haltens eines gespeicherten Bits in dem Speicherknoten, Versorgungs- und Polarisationsspannungen, welche den n-TFET und den p-TFET invers in einem Zustand polarisieren, in welchem ein Leitungsstrom durch Tunneleffekt von Band zu Band in dem n-TFET und in dem p-TFET erhalten wird;

- während eines Schreibens eines Bits in dem Speicherknoten, Versorgungs- und Polarisationsspannungen, welche direkt den n-TFET und den p-TFET polarisieren, und derart, dass einer aus dem n-TFET und dem p-TFET sich in einem blockierten Zustand befindet und der andere aus dem n-TFET und dem p-TFET sich in einem durchlassenden Zustand befindet.

2. SRAM-Speicherzelle (100) nach Anspruch 1, wobei während eines Schreibens eines Bits in dem Speicherknoten (106) der Wert der an die zweite Elektrode des n-TFET (102) angelegten Versorgungsspannung gleich dem Wert der an die zweite Elektrode des p-TFET (104) während eines Haltens eines gespeicherten Bits in dem Speicherknoten angelegten Versorgungsspannung ist, und der Wert der an die zweite Elektrode des p-TFET angelegten Versorgungsspannung gleich dem Wert der an die zweite Elektrode des n-TFET während eines Haltens eines gespeicherten Bits in dem Speicherknoten angelegten Versorgungsspannung ist.

3. SRAM-Speicherzelle (100) nach einem der vorhergehenden Ansprüche, wobei die Steuerschaltung (200) in der Lage ist, unterschiedliche Polarisationsspannungen zu jedem der Gates des n-TFET (102) und des p-TFET (104) zu liefern.

4. SRAM-Speicherzelle (100) nach Anspruch 3, wobei während des Haltens eines in dem Speicherknoten (106) gespeicherten Bits der Wert der an das Gate des n-TFET (102) angelegten Polarisationsspannung größer als der Wert der an die zweiten Elektroden des n-TFET und p-TFET (104) angelegten Versorgungsspannungen ist, und der Wert der an das Gate des p-TFET angelegten Polarisationsspannung kleiner als der Wert der an die zweiten Elektroden des n-TFET und p-TFET angelegten Versorgungsspannungen ist.

5. SRAM-Speicherzelle (100) nach einem der Ansprüche 3 und 4, wobei während eines Schreibens eines Bits in dem Speicherkoten (106):

- in der ersten Konfiguration der Wert der an dem Gate des n-TFET (102) angelegten Polarisationsspannung zwischen den Werten der an den zweiten Elektroden des n-TFET und p-TFET (104) angelegten Versorgungsspannungen liegt, wenn das Bit "1" ist, und der Wert der an dem Gate des p-TFET (104) angelegten Polarisationsspannung zwischen den Werten der an den zweiten Elektroden des n-TFET und p-TFET angelegten Versorgungsspannungen liegt, wenn das Bit "0" ist;

- in der zweiten Konfiguration der Wert der an dem Gate des p-TFET angelegten Polarisationsspannung zwischen den Werten der an den zweiten Elektroden des n-TFET und p-TFET angelegten Versorgungsspannungen liegt, wenn das Bit "1" ist, und der Wert der an dem Gate des n-TFET angelegten Polarisationsspannung zwischen den Werten der an den zweiten Elektroden des n-TFET und p-TFET angelegten Versorgungsspannungen liegt, wenn das Bit "0" ist.

6. SRAM-Speicherzelle (100) nach einem der Ansprüche 1 und 2, wobei in der zweiten Konfiguration die Steuerschaltung (200) in der Lage ist, eine einzelne Polarisationsspannung an die Gates des n-TFET (102) und des p-TFET (104) zu liefern.

7. SRAM-Speicherzelle (100) nach Anspruch 6, wobei während des Haltens eines gespeicherten Bits in dem Speicherknoten (106) der Wert der an den Gates des n-TFET (102) und des p-TFET (104) angelegten Polarisationsspannung zwischen den Werten der an den zweiten Elektroden des n-TFET und p-TFET angelegten Versorgungsspannungen liegt.

8. SRAM-Speicherzelle (100) nach einem der Ansprüche 6 und 7, wobei während eines Schreibens eines Bits in dem Speicherknoten (106) der Wert der an den Gates des n-TFET (102) und des p-TFET (104) angelegten Polarisationsspannung gleich dem größten Wert aus den Werten der an die zweiten Elektroden des n-TFET und p-TFET angelegten Versorgungsspannungen ist, wenn das Bit "1" ist, und der Wert der an den Gates des n-TFET und p-TFET angelegten Polarisationsspannung gleich dem kleinsten Wert aus den Werten der an den zweiten Elektroden des n-TFET und p-TFET angelegten Versorgungsspannungen ist, wenn das Bit "0" ist.

9. SRAM-Speicherzelle (100) nach einem der vorhergehenden Ansprüche, ferner umfassend:

- einen Leseanschluss (108, 114) mit einer mit dem Speicherknoten (106) verbundenen ersten Elektrode;
- eine Reihe von Lesebits (110), welche mit einer zweiten Elektrode des Leseanschlusses verbunden ist;
- eine erste Reihe von Lesewörtern (112), welche mit einer dritten Elektrode des Leseanschlusses verbunden sind;

und wobei die Steuerschaltung (200) dazu eingerichtet ist, eine Vorladespannung an der Reihe von Lesebits und eine Lese-Steuerspannung an der ersten Reihe von Lesewörtern anzulegen.

10. SRAM-Speicherzelle (100) nach Anspruch 9, wobei der Leseanschluss einen ersten Lese-TFET (108) umfasst, wobei die erste Elektrode dem Gate des ersten Lese-TFET entspricht, wobei die zweite Elektrode einem aus der Source und dem Drain des ersten Lese-TFET entspricht, und die dritte Elektrode dem anderen aus der Source und dem Drain des ersten Lese-TFET entspricht.

11. SRAM-Speicherzelle (100) nach Anspruch 10, wobei der Leseanschluss ferner einen zweiten Lese-TFET (114) mit einer entgegengesetzten Leitfähigkeit zu derjenigen des ersten Lese-TFET umfasst, wobei das Gate des zweiten Lese-TFET mit dem Speicherknoten (106) verbunden ist, eines aus der Source und dem Drain des zweiten Lese-TFET mit der Reihe von Lesebits (110) verbunden ist, und das andere aus der Source und dem Drain des zweiten Lese-TFET mit einer zweiten Reihe von Lesewörtern (112) verbunden ist.

12. Netz von SRAM-Speicherzellen (1000), umfassend mehrere SRAM-Speicherzellen (100) nach einem der Ansprüche 9 bis 11, wobei die SRAM-Speicherzellen gemäß einem Netz von mehreren Linien und mehreren Spalten angeordnet sind, wobei:

- jede Linie von Lesebits (110) allen SRAM-Speicherzellen gemein ist, welche einer gleichen Spalte des Netzes zugehörig sind;
- jede Linie von Lesewörtern (112) allen SRAM-Speicherzellen gemein ist, welche einer gleichen Linie des Netzes zugehörig sind;
- wenn die Steuerschaltung (200) in der Lage ist, verschiedene Polarisationsspannungen an jedes der Gates des n-TFET (102) und des p-TFET (104) zu liefern, die Gates des n-TFET von allen SRAM-Speicherzellen, welche einer gleichen Spalte des Netzes zugehörig sind, miteinander verbunden sind, und die Gates des p-TFET von allen SRAM-Speicherzellen, welche einer gleichen Spalte des Netzes zugehörig sind, miteinander verbunden sind; oder

- wenn die Steuerschaltung in der Lage ist, eine einzelne Polarisationsspannung an die Gates des n-TFET und des p-TFET zu liefern, die Gates des n-TFET und des p-TFET von allen SRAM-Speicherzellen, welche einer gleichen Spalte des Netzes zugehörig sind, miteinander verbunden sind.

13. SRAM-Speichervorrichtung (2000), umfassend eine Mehrzahl von Netzen von SRAM-Speicherzellen (1000) nach Anspruch 12, wobei die Steuerschaltung (2002.1, 2002.2, 2004.1, 2004.2, 2006) der Mehrzahl von Netzen von SRAM-Speicherzellen gemein ist und eine Mehrzahl von CMOS-Transistoren umfasst.

**Claims**

1. SRAM memory bit cell (100) comprising at least:

   - a n-TFET (102) and a p-TFET (104);
   - a storage node (106) formed by the connection of a first electrode of the n-TFET to a first electrode of the p-TFET, the first electrodes being, in a first configuration, the drains of the n-TFET and p-TFET, or, in a second configuration, the sources of the n-TFET and p-TFET;
   - a control circuit (200) able to apply supply voltages on second electrodes of the n-TFET and p-TFET, the second electrodes being, in the first configuration, the sources of the n-TFET and p-TFET, or, in the second configuration, the drains of the n-TFET and p-TFET, and to supply bias voltages on the gates of the n-TFET and p-TFET;

   wherein the control circuit is configured to provide:

   - during a retention of a bit stored in the storage node, supply and bias voltages reverse biasing the n-TFET and p-TFET in a state wherein a conduction current is obtained by band-to-band tunneling in the n-TFET and p-TFET;
   - during a writing of a bit in the storage node, supply and bias voltages forward biasing the n-TFET and p-TFET and such that one of the n-TFET and p-TFET is in OFF state and that the other of the n-TFET and p-TFET is in ON state.

2. SRAM memory bit cell (100) according to claim 1, wherein, during a writing of a bit in the storage node (106), the value of the supply voltage applied on the second electrode of the n-TFET (102) is equal to the value of the supply voltage applied on the second electrode of the p-TFET (104) during a retention of a bit stored in the storage node, and the value of the supply voltage applied on the second electrode of the p-TFET is equal to the value of the supply voltage applied on the second electrode of the n-TFET during a retention of a bit stored in the storage node.

3. SRAM memory bit cell (100) according to one of previous claims, wherein the control circuit (200) is able to provide different bias voltages on each of the gates of the n-TFET (102) and p-TFET (104).

4. SRAM memory bit cell (100) according to claim 3, wherein, during the retention of a bit stored in the storage node (106), the value of the bias voltage applied on the gate of the n-TFET (102) is higher than the value of the supply voltages applied on the second electrodes of the n-TFET and p-TFET (104), and the value of the bias voltage applied on the gate of the p-TFET is lower than the value of the supply voltages applied on the second electrodes of the n-TFET and p-TFET.

5. SRAM memory bit cell (100) according to one of claims 3 and 4, wherein, during a writing of a bit in the storage node (106):

   - in the first configuration, the value of the bias voltage applied on the gate of the n-TFET (102) is between the values of the supply voltages applied on the second electrodes of the n-TFET and p-TFET (104) if the bit is "1" and the value of the bias voltage applied on the gate of the p-TFET is between the values of the supply voltages applied on the second electrodes of the n-TFET and p-TFET if the bit is "0";
   - in the second configuration, the value of the bias voltage applied on the gate of the p-TFET is between the values of the supply voltages applied on the second electrodes of the n-TFET and p-TFET if the bit is "1" and the value of the bias voltage applied on the gate of the n-TFET is between the values of the supply voltages applied on the second electrodes of the n-TFET and p-TFET if the bit is "0".

6. SRAM memory bit cell (100) according to one of claims 1 and 2, wherein, in the second configuration, the control circuit (200) is able to provide a single bias voltage on the gates of the n-TFET (102) and p-TFET (104).

7. SRAM memory bit cell (100) according to claim 6, wherein, during the retention of a bit stored in the storage node (106), the value of the bias voltage applied on the gates of the n-TFET (102) and p-TFET (104) is between the values of the supply voltages applied on the second electrodes of the n-TFET and p-TFET.

8. SRAM memory bit cell (100) according to one of claims 6 and 7, wherein, during a writing of a bit in the storage node (106), the value of the bias voltage applied on the gates of the n-TFET (102) and p-TFET (104) is equal to the highest value among the values of the supply voltages applied on the second electrodes of the n-TFET and p-TFET if the bit is "1", and the value of the bias voltage applied on the gates of the n-TFET and p-TFET is equal to the lowest value among the values of the supply voltages applied on the second electrodes of the n-TFET and p-TFET if the bit is "0".

9. SRAM memory bit cell (100) according to one of previous claims, further comprising:

   - a read port (108, 114) having a first electrode connected to the storage node (106);
   - a read bit line (110) connected to a second electrode of the read port;
   - a first read word line (112) connected to a third electrode of the read port;

   and wherein the control circuit (200) is configured to apply a pre-charge voltage on the read bit line and a read control voltage on the first read word line.

10. SRAM memory bit cell (100) according to claim 9, wherein the read port comprises a first read TFET (108), the first electrode corresponding to the gate of the first read TFET, the second electrode corresponding to one of the source and drain of the first read TFET and the third electrode corresponding to the other one of the source and drain of the first read TFET.

11. SRAM memory bit cell (100) according to claim 10, wherein the read port further comprises a second read TFET (114) having a conductivity opposite to that of the first read TFET, wherein the gate of the second read TFET is connected to the storage node (106), one of the source and drain of the second read TFET is connected to the read bit line (110) and the other one of the source and drain of the second read TFET is connected to a second read word line (112).

12. SRAM memory bit cells array (1000) comprising several SRAM memory bit cells (100) according to one of claims 9 to 11, wherein the SRAM memory bit cells are arranged according to an array of several lines and several columns, and wherein:

   - each read bit line (110) is common to all SRAM memory bit cells belonging to a same column of the array;
   - each read word line (112) is common to all SRAM memory bit cells belonging to a same row of the array;
   - when the control circuit (200) is able to provide different bias voltages on each of the gates of the n-TFET (102) and p-TFET (104), the gates of the n-TFET of all SRAM memory bit cells belonging to a same column of the array are connected together and the gates of the p-TFET of all SRAM memory bit cells belonging to a same column of the array are connected together; or
   - when the control circuit is able to provide a single bias voltage on the gates of the n-TFET and p-TFET, the gates of the n-TFET and p-TFET of all SRAM memory bit cells belonging to a same column of the array are connected together.

13. SRAM memory device (2000) comprising several SRAM memory bit cells arrays (100) according to claim 12, wherein the control circuit (2002.1, 2002.2, 2004.1, 2004.2, 2006) is common to the several SRAM memory bit cells arrays and comprises several CMOS transistors.

FIG.1

FIG.2a    FIG.2b    FIG.2c

FIG.3

FIG.4

FIG.5

FIG.6

FIG.7

FIG.8

FIG.9

1000.1   2002.1   1000.2   ↙2000

2004.1

2006

2004.2

FIG.10

1000.3   2002.2   1000.4

46

48

100

10

Retard [ns]

1

0

49

0,3   0,4   0,5   0,6

Tension d'alimentation de cellule [V]

FIG.11

FIG.12

FIG.13

FIG.14

FIG.15

FIG.16

FIG.17

FIG.18

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012106236 A
- US 20110299326 A1

**Littérature non-brevet citée dans la description**

- **C. ANGHEL et al.** 30-nm Tunnel FET with improved performance and reduced ambipolar current. *IEEE Transactions on Electron Devices,* 2011
- **A. MAKOSIEJ et al.** A 32 nm Tunnel FET SRAM for Ultra Low Leakage. *ISCAS,* 2012
- **TOSHIKAZU FUKUDA ; KOJI KOHARA et al.** A 7ns-Access-Time 25$\mu$W/MHz 128kb SRAM for Low-Power Fast Wake-Up MCU in 65 nm CMOS with 27fA/b Rétention Current. *ISSCC,* 2014